# FASCICULE DE BREVET EUROPEEN

(11) **EP 1 331 737 B1**
(45) Date de publication et mention de la délivrance du brevet: **12.09.2007**
(21) Numéro de dépôt: 02364041.0
(22) Date de dépôt: 15.11.2002
(51) Int. Cl.: H03K 5/1534

(54) **Circuit de génération d'impulsions, et composant micro-électronique correspondant**
Pulsgeneratorschaltung und entsprechendes mikroelektronisches Bauelement
Pulse generating circuit, and corresponding microelectronic component

(30) Priorité: 19.11.2001 FR 0114965
(43) Date de publication de la demande: 30.07.2003
(73) Titulaire: ATMEL NANTES SA, 44306 Nantes Cédex 3 (FR)
(72) Inventeur: Coloma, Bernard, 44300 Nantes (FR)
(74) Mandataire: Vidon, Patrice

(56) Documents cités:
- US-A- 4 535 459
- US-A- 5 374 894
- US-A- 5 406 134
- US-A- 5 751 644
- US-A- 5 767 718

## Description

Le domaine de l'invention est celui des dispositifs micro-électroniques. Plus précisément, l'invention concerne la génération d'impulsions calibrées, pour le contrôle ou la mise en oeuvre de composants micro-éléctroniques tels que, par exemple, des mémoires. Dans ce cas, la génération d'impulsions est nécessaire pour contrôler les accès en lecture ou en écriture à la mémoire.

Bien sûr, l'invention ne se limite pas à cette application, mais peut être utilisée dans tous les cas où des impulsions calibrées sont nécessaires.

Plus précisément, l'invention est relative à la génération d'impulsions calibrées à partir de deux signaux d'entrée, une impulsion de base, ou signal de commande (appelé par la suite PH_IN), et un signal de contrôle (appelé par la suite ENABLE). Le fonctionnement d'un générateur d'impulsions calibrées est alors le suivant : il génère une impulsion calibrée à la fin d'une impulsion de base, et commande l'arrêt anticipé de l'impulsion générée, sous l'action du signal de contrôle ou à réception d'une nouvelle impulsion de base.

Selon l'art antérieur, la génération d'impulsions calibrées est obtenue à l'aide d'un système combinatoire, constitué de portes logiques.

Le document de brevet US 5,751,644 décrit un tel système combinatoire.

Un inconvénient majeur de l'utilisation d'un bloc constitué de portes logiques combinées et qu'un tel bloc est difficile à calibrer, et est très dépendant des variations du procédé de fabrication et de la température. Les écarts de temps de propagation à l'intérieur des différentes couches des portes logiques ne sont en conséquence pas efficacement maîtrisés, ce qui peut entraîner l'apparition d'impulsions parasites.

Ces problèmes sont bien sûr d'autant plus importants que la technologie est fine et/ou que l'horloge de base est rapide.

Ces impulsions parasites peuvent être particulièrement néfastes. Par exemple, dans le cas d'une mémoire, elles peuvent conduire à l'écriture intempestive de données quelconques et aléatoires, et donc à perturber ou bloquer le fonctionnement du dispositif équipé de cette mémoire.

L'invention selon la revendication 1 a donc pour objectif de pallier ces inconvénients de l'état de la technique.

Plus précisément, l'invention a pour objectif de fournir un circuit de génération d'impulsions, à partir d'une impulsion de base et d'un signal de contrôle, qui ne produise pas d'impulsions parasites en sortie.

Un autre objectif de l'invention est de fournir un tel circuit, qui soit simple, en termes de nombre de composants et de surface de silicium, et qui puisse aisément être réalisé et adapté à un composant micro-électronique.

En particulier, un objectif de l'invention est de fournir un tel circuit, nécessitant un nombre réduit de transistors, par rapport aux systèmes logiques.

Encore un autre objectif de l'invention est de fournir un tel circuit, qui puisse être adapté à tout type de système asynchrone, notamment des mémoires, et en particulier des mémoires rapides.

Ces objectifs, ainsi que d'autres qui apparaîtront par la suite, sont atteints à l'aide d'un circuit micro-électronique de génération d'impulsions, délivrant sur une sortie une impulsion en fonction de deux signaux d'entrée, un signal de commande (PH_IN) et un signal de contrôle (ENABLE).

Selon l'invention, ce circuit comprend un premier et un second points mémoire et un module de retard montés en série, ledit module de retard délivrant en sortie ladite impulsion, lesdits points mémoire comprenant chacun des moyens de remise à zéro contrôlés respectivement par ledit signal de commande et ledit signal de contrôle.

Un tel circuit, qui repose sur une approche analogique et non plus logique, s'avère particulièrement efficace, comme on le verra par la suite, tout en nécessitant un nombre limité de transistors. Il supprime efficacement la génération d'impulsions parasites, dues aux temps de propagation dans des portes logiques.

De façon avantageuse, lesdits points mémoire sont des points mémoire identiques, montés en opposition de phase.

De façon préférentielle, lesdits moyens de remise à zéro sont pilotés de façon à positionner ledit circuit dans un état prédéterminé lors de son initialisation, et à interrompre la génération d'une impulsion dès que l'un desdits signaux d'entrée prend une valeur prédéterminée.

Avantageusement :
- les moyens de remise à zéro dudit premier point mémoire sont pilotés par ledit signal de commande inversé ;
- les moyens de remise à zéro dudit second point mémoire sont pilotés par ledit signal de contrôle.

Selon un mode de réalisation préférentiel, lesdits points mémoire comprennent chacun deux inverseurs rebouclés, suivis d'un troisième inverseur alimentant la sortie dudit point mémoire.

De façon avantageuse, l'accès à chacun desdits points mémoire se fait via une porte de transfert Nmos/Pmos. Préférentiellement, lesdits moyens de remise à zéro comprennent un transistor Nmos.

Selon un aspect avantageux de l'invention, ledit module de retard est activé par un front montant sur la sortie dudit second point mémoire.

De façon préférentielle, ledit module de retard comprend un élément de retard inverseur, une porte NAND et un inverseur, délivrant ladite impulsion.

L'invention concerne également les composants micro-électroniques, comprenant au moins un circuit micro-électronique de génération d'impulsions tel que décrit ci-dessus.

Lesdits circuits peuvent notamment contrôler des accès en lecture et/ou en écriture d'une mémoire.

D'autres caractéristiques et avantages de l'invention apparaîtront plus clairement à la lecture de la description suivant d'un mode de réalisation préférentiel de l'invention, donné à tire de simple exemple illustratif et non limitatif, et des dessins annexés, parmi lesquels :
- la figure 1 est un schéma synoptique illustrant le principe général de l'invention ;
- la figure 2 présent de façon détaillée un mode de réalisation du schéma de la figure 1 ;
- la figure 3 illustre une simulation des signaux principaux du circuit de la figure 2.

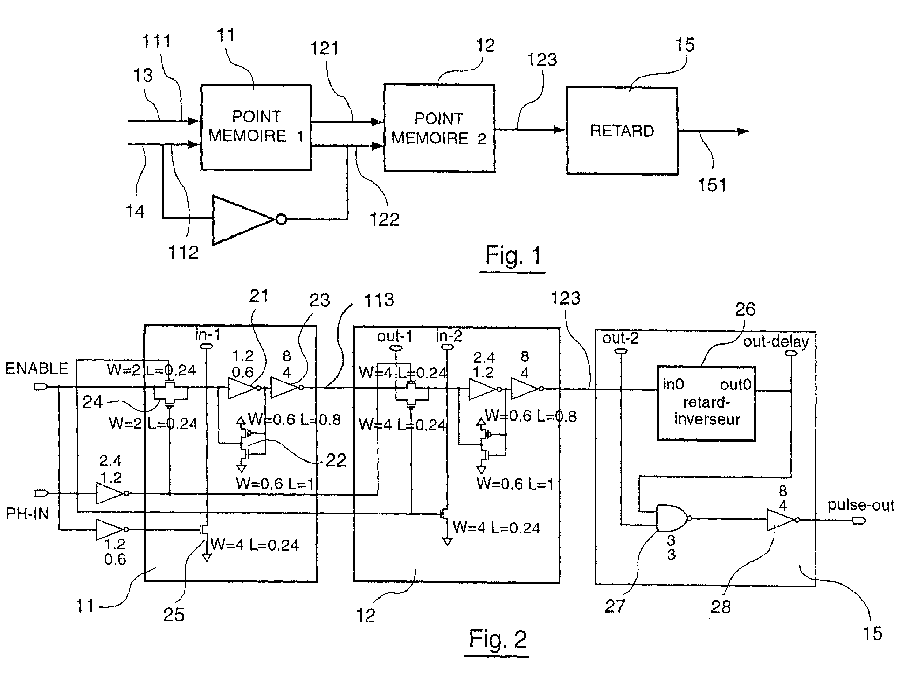

Comme expliqué plus haut, pour éviter la création d'impulsions parasites présents dans les circuits combinatoires, générées par des différences de temps de propagation à travers différentes couches logiques, l'invention repose sur une approche tout à fait différente, à savoir un système à base de deux point mémoire et d'un module de retard montés en série, ainsi que cela est illustré en figure 1.

Chaque point mémoire 11, 12 possède une première entrée 111, 121 permettant de le forcer à zéro (ré-initialisation, ou « reset » du point mémoire) et une seconde entrée de commande 112, 122.

La sortie 123 du second point mémoire 12 agit sur un étage de sortie 15 comprenant un bloc de retard sur un front qui délivre en sortie 151 des impulsions calibrées.

Selon le mode de réalisation décrit, les deux points mémoire 11 et 12 sont identiques, et montés en opposition de phase. A la mise en marche du système, le signal de contrôle 14, ou « reset », permet de positionner ce système dans sa bonne configuration. Il permet également d'arrêter la génération d'une impulsion en sortie, en fonction des deux signaux d'entrée 13 et 14.

Une particularité de ce système est le contrôle de la ré-initialisation (« reset ») des deux points mémoire 11 et 12. La ré-initialisation du premier point mémoire 11 est effectuée par le signal d'entrée 13 inversé, et la ré-initialisation du second point mémoire 12 est assurée par le signal de contrôle 14.

La durée de l'impulsion en sortie 151 est gérée par le bloc de retard. L'étage de sortie 15, constitué de ce bloc de retard et de portes logiques, produit un retard sur le front montant du signal 123 en sortie du second point mémoire 12.

Selon le mode de réalisation illustré par la figure 2, chaque point mémoire 11, 12 comprend deux inverseurs rebouclés 21, 22, suivis d'un troisième inverseur 23 destiné à rétablir la bonne polarité en sortie du point mémoire (les deux points mémoire 11 et 12 étant identiques, seul le premier est décrit).

L'accès au point mémoire s'effectue par une porte de transfert 24 (« pass-gate ») Nmos/Pmos. Un transistor Nmos 25 permet de forcer à zéro (« reset ») le point mémoire, en agissant sur l'inverseur 21.

L'étage de sortie 15 comprend un bloc de retard inverseur 26 sur un front montant du signal de sortie 123 du second point mémoire 12, d'une porte NAND et d'un inverseur 28. Le bloc de retard 26 est constitué d'inverseurs et de capacités, et génère un retard RC, qui est fixe dans ce mode de réalisation, mais pourrait bien sûr être réglable et/ou programmable.

On ne décrit pas en détail le bloc de retard 26, qui est connu en soi. De la même façon, la structure de l'inverseur 22 et de la porte de transfert 24 sont connus. On peut, en tant que de besoin, se référer à la figure 2, sensiblement plus détaillée. De même, on pourra se référer à la figure 2 pour l'ensemble des connexions des composants.

Les dimensions des différents transistors apparaissant sur cette figure 2 sont bien sûr données à titre de simples exemples.

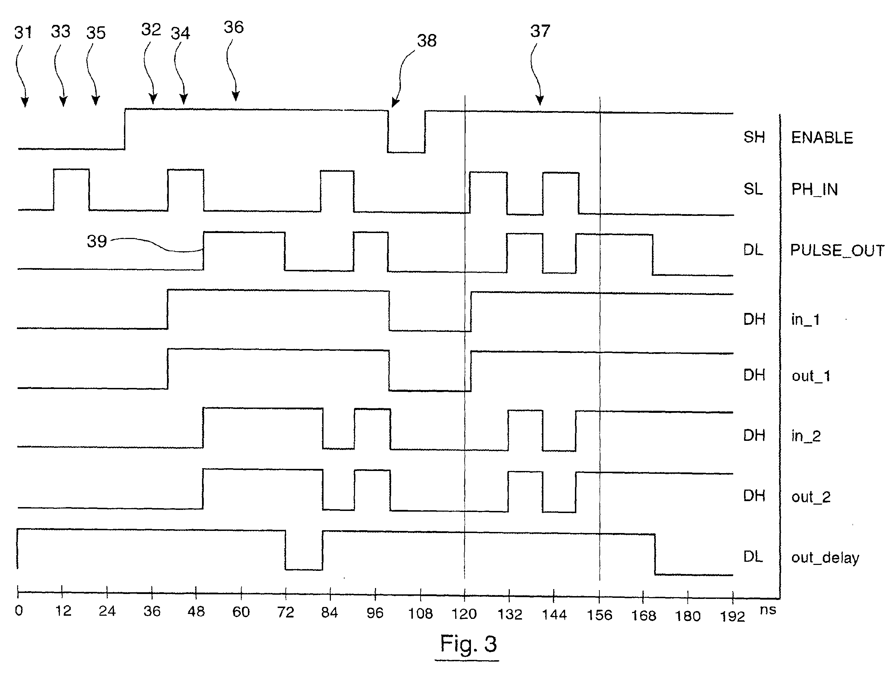

On décrit maintenant le fonctionnement du circuit de la figure 2, à l'aide notamment de la simulation de la figure 3. Les signaux illustrés sont les suivants :
- l'impulsion d'entrée 13 est le signal PH_IN ;
- le signal de contrôle 14 est le signal ENABLE ;
- la sortie 151 du bloc est le signal PULSE_OUT ;
- l'entrée 111 du premier point mémoire 11 est le signal IN_1 ;
- la sortie 113 du premier point mémoire 11 est le signal OUT_1 ;
- l'entrée 121 du deuxième point mémoire 12 est le signal IN_2 ;
- la sortie 123 du deuxième point mémoire 12 est le signal OUT_2.

On retrouve cette terminologie sur la figure 2.

A l'initialisation (31), le signal de contrôle ENABLE est à 0 : il force à 0 le premier point mémoire. L'impulsion d'entrée PH_IN est à 0 : elle met passant la porte de transfert d'entrée du second point mémoire. Ainsi la sortie 113 du premier point mémoire force à 0 le second point mémoire 12 à travers la porte de transfert qui est passant lorsque PH_IN est à 0.

Les deux points mémoire sont ainsi forcés à 0, et la sortie est à 0 (pas d'impulsion générée).

Lorsque le signal ENABLE passe à 1 et PH_IN est à 0 (32), la ré-initialisation du premier point mémoire 11 s'arrête. Cependant, la porte de transfert du premier point mémoire 11, 12 et la sortie 151 restent à 0.

Lorsque le signal PH_IN passe à 1 et ENABLE est à 0 (33), la porte de transfert du premier point mémoire 11 devient passante, et la porte de transfert du second point mémoire 12 se bloque. La ré-initialisation du second point mémoire 12 est activée. En conséquence, le premier point mémoire 11 prend la valeur du signal ENABLE, c'est-à-dire 0.

Lorsque le signal PH_IN passe à 1 et ENABLE est à 1 (34), la porte de transfert du premier point mémoire 11 devient passante, et la porte de transfert du second point mémoire 12 se bloque. La ré-initialisation, le reset du second point mémoire 12 est activé. Le premier point mémoire 11 prend la valeur du signal ENABLE, c'est-à-dire 1.

Lorsque le signal PH_IN passe à 0, la porte de transfert du premier point mémoire 11 se bloque, et la porte de transfert du second point mémoire 12 devient passante. La ré-initialisation de second point mémoire 12 est désactivé. Le second point mémoire 12 prend donc la valeur du signal de sortie 113 du premier point mémoire 11, soit :
- si ENABLE était égale à 0 (35), la valeur 0 se propage du premier point mémoire 11 au second 12, et il n'y a pas création d'impulsion en sortie du système.
- si ENABLE était égale à 1 (36), la valeur 1 se propage du premier point mémoire 11 au second 12. Il y a alors création d'une impulsion calibrée 39 en sortie du système.

Lors de la création de l'impulsion calibrée (aspect précédent), la génération de l'impulsion peut être interrompue dans les deux cas suivants :
- si PH_IN passe à 1 (37), alors le second point mémoire 12 est forcé à 0 : la sortie out_2 revient à 0, l'impulsion en sortie 15 se termine.
- si ENABLE passe à 0 (38), le premier point mémoire 11 est forcé à 0. Le 0 se propage au second point mémoire 12 à travers la porte de transfert de ce dernier : la sortie out_2 revient à 0, et l'impulsion en sortie 151 se termine.

Bien entendu, d'autres modes de mise en oeuvre peuvent être développés, dans le cadre de l'invention.

## Revendications

1. Circuit micro-électronique de génération d'impulsions, délivrant sur une sortie une impulsion (pulse_out) en fonction de premier (in_1) et second (in_2) signaux d'entrée, un signal de commande (PH_IN) et un signal de contrôle (ENABLE),
**caractérisé en ce qu**'il comprend un premier (11) et un second (12) points mémoire et un module de retard (15) montés en série, ledit module de retard (15) délivrant en sortie ladite impulsion (pulse_out),
lesdits points mémoire (11, 12) comprenant chacun des moyens de remise à zéro (25) contrôlés respectivement par ledit signal de contrôle (ENABLE) et ledit signal de commande (PH_IN),
ledit premier point mémoire (11) recevant en entrée ledit premier signal d'entrée (in_1),
ledit second point mémoire (12) recevant en entrée ledit second signal d'entrée (in_2),
et **en ce que** l'accès à chacun desdits points mémoire (11) se fait via une porte de transfert (24),
la sortie du premier point mémoire (11) étant reliée à la porte de transfert du second point mémoire (12).

2. Circuit selon la revendication 1, **caractérisé en ce que** lesdits points mémoire (11, 12) sont des points mémoire identiques montés en opposition de phase.

3. Circuit selon l'une quelconque des revendications 1 et 2, **caractérisé en ce que** lesdits moyens de remise à zéro (25) sont pilotés de façon à positionner ledit circuit dans un état prédéterminé lors de son initialisation, et à interrompre la génération d'une impulsion dès que l'un desdits signaux d'entrée (in_1, in_2) prend une valeur prédéterminée.

4. Circuit selon l'une quelconque des revendications 1 à 3, **caractérisé en ce que**:
- les moyens de remise à zéro (25) dudit premier point mémoire (11) sont pilotés par ledit signal de contrôle (ENABLE) inversé ;
- les moyens de remise à zéro dudit second point mémoire (12) sont pilotés par ledit signal de commande (PH_IN).

5. Circuit selon l'une quelconque des revendications 1 à 4, **caractérisé en ce que** lesdits points mémoire (11, 12) comprennent chacun deux inverseurs rebouclés (21, 22), suivis d'un troisième inverseur (23) alimentant la sortie dudit point mémoire.

6. Circuit selon l'une quelconque des revendications 1 à 5, **caractérisé en ce que** l'accès à chacun desdits points mémoire se fait via une porte de transfert Nmos/Pmos.

7. Circuit selon l'une quelconque des revendications 2 à 6, **caractérisé en ce que** lesdits moyens de remise à zéro (25) comprennent un transistor Nmos.

8. Circuit selon l'une quelconque des revendications 1 à 7, **caractérisé en ce que** ledit module de retard (15) est activé par un front montant sur la sortie dudit second point mémoire (12).

9. Circuit selon la revendication 8, **caractérisé en ce que** ledit module de retard (15) comprend un élément de retard inverseur (26), une porte NAND et un inverseur (28), délivrant ladite impulsion.

10. Composant micro-électronique, **caractérisé en ce qu**'il comprend au moins un circuit micro-électronique de génération d'impulsions selon l'une quelconque des revendications 1 à 9.

11. Composant micro-électronique selon la revendication 10, **caractérisé en ce qu**'au moins un desdits circuits contrôle des accès en lecture et/ou en écriture d'une mémoire.

## Claims

1. Microelectronic circuit for generating pulses, delivering a pulse (pulse_out) on an output as a function of first (in_1) and second (in_2) input signals, a command signal (PH_IN) and a control signal (ENABLE), **characterised in that** it comprises a first (11) and a second (12) memory node and a delay module (15), which are mounted in series, the said delay module (15) delivering the said pulse (pulse_out) at its output,
the said memory nodes (11, 12) each comprising reset means (25) controlled respectively by the said control signal (ENABLE) and the said command signal (PH_IN),
the said first memory node (11) receiving the said first input signal (in_1) at its input,
the said second memory node (12) receiving the said second input signal (in_2) at its input,
and **in that** each of the said memory nodes (11) is accessed via a pass gate (24),
the output of the first memory node (11) being connected to the pass gate of the second memory node (12).

2. Microelectronic circuit according to Claim 1, **characterised in that** the said memory nodes (11, 12) are identical memory nodes mounted in phase opposition.

3. Microelectronic circuit according to either of Claims 1 and 2, **characterised in that** the said reset means (25) are driven so as to place the said circuit in a predetermined state during its initialisation, and to interrupt the generation of a pulse as soon as one of the said input signals (in_1, in_2) takes a predetermined value.

4. Microelectronic circuit according to any one of Claims 1 to 3, **characterised in that**:
- the reset means (25) of the said first memory node (11) are driven by the said control signal (ENABLE) inverted;
- the reset means of the said second memory node (12) are driven by the said command signal (PH_IN).

5. Microelectronic circuit according to any one of Claims 1 to 4, **characterised in that** the said memory nodes (11, 12) each comprise two fed-back inverters (21, 22), followed by a third inverter (23) supplying the output of the said memory node.

6. Microelectronic circuit according to any one of Claims 1 to 5, **characterised in that** each of the said memory nodes is accessed via an Nmos/Pmos pass gate.

7. Microelectronic circuit according to any one of Claims 2 to 6, **characterised in that** the said reset means (25) comprise an Nmos transistor.

8. Microelectronic circuit according to any one of Claims 1 to 7, **characterised in that** the said delay module (15) is activated by a leading edge on the output of the said second memory node (12).

9. Microelectronic circuit according to Claim 8, **characterised in that** the said delay module (15) comprises an inverting delay element (26), a NAND gate and an inverter (28), delivering the said pulse.

10. Microelectronic component, **characterised in that** it comprises at least one microelectronic circuit for generating pulses according to any one of Claims 1 to 9.

11. Microelectronic component according to Claim 10, **characterised in that** at least one of the said circuits controls read and/or write accesses of a memory.

## Patentansprüche

1. Mikroelektronische Schaltung zur Impulserzeugung, die einen Impuls (pulse_out) abhängig von ersten (in_1) und zweiten (in_2) Eingangssignalen, ein Steuersignal (PH_IN) und ein Kontrollsignal (ENABLE) ausgibt,
**dadurch gekennzeichnet, dass** sie einen ersten (11) und zweiten (12) Speicherpunkt und ein Verzögerungsmodul (15) aufweist, die in Reihe geschaltet sind, wobei dieses Verzögerungsmodul (15) den Impuls (pulse_out) ausgibt,
die Speicherpunkte (11, 12) beide Rückstellmittel (25) aufweisen, die jeweils durch das Kontrollsignal (ENABLE) und das Steuersignal (PH_IN) gesteuert werden,
der erste Speicherpunkt (11) an seinem Eingang das erste Eingangssignal (in_1) empfängt,
der zweite Speicherpunkt (12) an seinem Eingang das zweite Eingangssignal (in_2) empfängt,
und **dadurch**, dass der Zugriff auf jeden der Speicherpunkte (11) über ein Transfergatter (24) erfolgt,
wobei der Ausgang des ersten Speicherpunkts (11) mit dem Transfergatter des zweiten Speicherpunkts (12) verbunden ist.

2. Schaltung nach Anspruch 1, **dadurch gekennzeichnet, dass** die Speicherpunkte (11, 12) identische Speicherpunkte sind, die gegenphasig angeordnet sind.

3. Schaltung nach einem der Ansprüche 1 und 2, **dadurch gekennzeichnet, dass** die Rückstellmittel (25) so gesteuert werden, dass sie die Schaltung bei ihrer Initialisierung in einen vorbestimmten Zustand versetzen und die Erzeugung eines Impulses unterbrechen, sobald eines der Eingangssignale (in_1, in_2) einen vorbestimmten Wert annimmt.

4. Schaltung nach einem der Ansprüche 1 bis 3, **dadurch gekennzeichnet, dass**:
- die Rückstellmittel (25) des ersten Speicherpunkts (11) durch das invertierte Kontrollsignal (ENABLE) gesteuert werden;
- die Rückstellmittel des zweiten Speicherpunkts (12) durch das Steuersignal (PH_IN) gesteuert werden.

5. Schaltung nach einem der Ansprüche 1 bis 4, **dadurch gekennzeichnet, dass** die Speicherpunkte (11, 12) jeder zwei eingeschleifte Umkehrschalter (21, 22) aufweisen, gefolgt von einem dritten Umkehrschalter (23), der den Ausgang dieses Speicherpunkts speist.

6. Schaltung nach einem der Ansprüche 1 bis 5, **dadurch gekennzeichnet, dass** der Zugriff auf jeden dieser Speicherpunkte über ein Nmos/Pmos-Transfergatter erfolgt.

7. Schaltung nach einem der Ansprüche 2 bis 6, **dadurch gekennzeichnet, dass** die Rückstellmittel (25) einen Nmos-Transistor umfassen.

8. Schaltung nach einem der Ansprüche 1 bis 7, **dadurch gekennzeichnet, dass** das Verzögerungsmodul (15) durch eine steigende Flanke am Ausgang des zweiten Speicherpunkts (12) aktiviert wird.

9. Schaltung nach Anspruch 8, **dadurch gekennzeichnet, dass** das Verzögerungsmodul (15) ein Umkehrschalter-Verzögerungselement (26), ein NAND-Gatter und einen Umkehrschalter (28) umfasst, der den Impuls ausgibt.

10. Mikroelektronisches Bauteil, **dadurch gekennzeichnet, dass** es mindestens eine mikroelektronische Schaltung zur Impulserzeugung nach einem der Ansprüche 1 bis 9 umfasst.

11. Mikroelektronisches Bauteil nach Anspruch 10, **dadurch gekennzeichnet, dass** mindestens eine der Schaltungen die Lese- und/oder Schreibzugriffe auf einen Speicher steuert.
